# EUROPEAN PATENT SPECIFICATION

(11) **EP 0 557 098 B1**
(45) Date of publication and mention of the grant of the patent: **29.04.1998**
(21) Application number: 93301202.3
(22) Date of filing: 18.02.1993
(51) Int. Cl.: H01L 21/768, H01L 27/148

(54) **Solid-State Image Pick-up Device and Method of manufacturing the same**
Festkörperbildaufnahme-Vorrichtung und Herstellungsverfahren
Dispositif de prise de vue à l'état solide et procédé de fabrication associé

(30) Priority: 20.02.1992 JP 33069/92
(43) Date of publication of application: 25.08.1993
(73) Proprietor: MATSUSHITA ELECTRONICS CORPORATION, Kadoma-shi, Osaka 571 (JP)
(72) Inventor: Mizushima, Kazuyoshi, Takatuki-shi, Osaka-fu 569 (JP); Okada, Hiroyuki, Osaka-shi 535 (JP)
(74) Representative: Read, Matthew Charles

(56) References cited:
- EP-A- 0 242 663
- EP-A- 0 353 665
- EP-A- 0 502 521
- US-A- 4 545 852
- US-A- 4 879 253
- US-A- 5 028 972
- US-A- 5 169 491
- PATENT ABSTRACTS OF JAPAN vol. 12, no. 357 (E-662)26 September 1988 &JP-A-63 111 668
- PATENT ABSTRACTS OF JAPAN vol. 16, no. 554 (E-1293)25 November 1992&JP-A-42 11 120
- PATENT ABSTRACTS OF JAPAN vol. 14, no. 413 (E-0974)6 September 1990 &JP-A-21 56 670

## Description

The present invention relates to a solid-state image pickup device comprising: a semiconductor substrate; a photodiode formed in said semiconductor substrate; a transfer channel formed in said semiconductor substrate spaced from the photodiode; a transfer gate electrode formed over said transfer channel on a gate dielectric film; an interlayer film formed on said transfer gate electrode; a first light-shield film formed on said interlayer film for shielding the transfer channel from light; a second light-shield film formed over the first light shield film; and an interlayer dielectric film between said first and second light-shield layers.

The present invention also relates to a method of manufacturing a solid-state image pickup device comprising: forming a photodiode in a semiconductor substrate; forming a transfer channel in said semiconductor substrate spaced from said photodiode; forming a gate dielectric film on said semiconductor substrate; forming a transfer gate electrode on the gate dielectric film; forming an interlayer film on said transfer gate electrode; forming a first light-shield film on said interlayer film for shielding said transfer channel from light; forming an interlayer dielectric film on said first light-shield film; smoothing said dielectric film; forming a second light-shield film on said interlayer dielectric film; and removing a portion of said second light-shield film by etching.

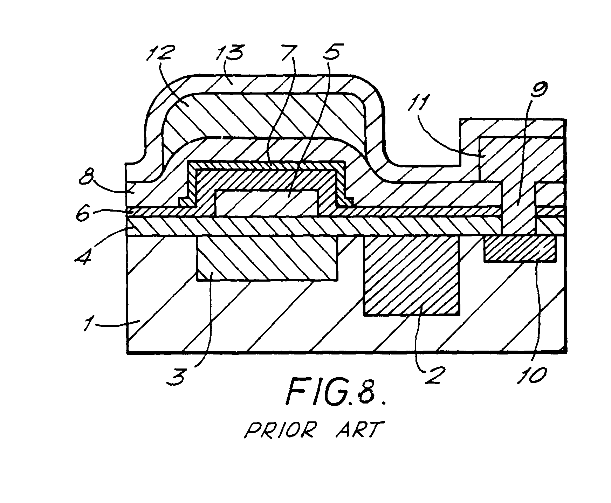

The structure of a conventional device will now be described with reference to Fig. 8 which is a sectional view of a solid-state image pickup device.

Impurities are selectively implanted in an N-type semiconductor substrate 1, and a photodiode 2 and a transfer channel 3 are formed by thermal diffusion. The photodiode 2 generates photo-carriers by photoelectrically converting light entering from outside. A transfer gate 5 is formed over the transfer channel 3 on the N-type semiconductor substrate 1 through a gate dielectric film 4. When a specific voltage pulse is applied to the transfer gate electrode 5, the photo-carriers in the photodiode 2 are transferred to the transfer channel 3. An interlayer film 6 is formed so as to cover the transfer gate electrode 5. A first light-shield film 7 is formed in a specific region on the interlayer film 6 so as to shield the transfer channel 3. As a result, the smear noise characteristic of the solid-state image pickup device is improved, as described in JP-A-02-156670.

In the portion contacting the N-type semiconductor substrate 1, a contact hole 9 is formed by removing the gate dielectric film 4, interlayer film 6 and interlayer dielectric film 8. In the bottom of the contact hole 9, a diffusion layer 10 is formed on the exposed N type semiconductor substrate 1. Through this contact hole 9, a wiring layer 11 is connected to the diffusion layer 10. The diffusion layer is formed in order to connect the N-type semiconductor substrate 1 and the wiring layer 11 well electrically. A second light-shield film 12 is formed on the first light-shield film 7 through the interlayer dielectric layer 8. Thus, the smear noise characteristic of the solid-state image pickup device may be improved.

Furthermore, a final protective film 13 is provided in order to protect the uppermost surface of the solid-state image pickup device.

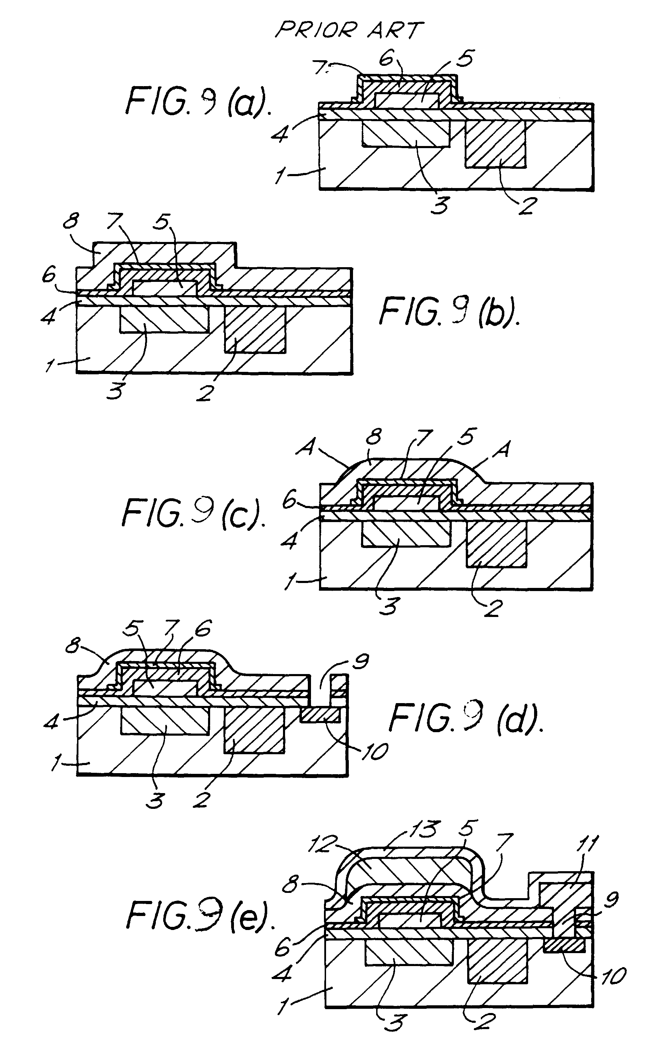

A conventional method of manufacturing a solid-state image pickup device will now be described with reference to Fig. 9.

In Fig. 9 (a), an N-type silicon substrate is used as the N-type semiconductor substrate 1. In the N-type semiconductor substrate 1, a photodiode 2 and a transfer channel 3 are formed by ion implantation and thermal diffusion. Afterwards, a gate dielectric film 4, a transfer gate electrode 5, an interlayer film 6, a first light-shield film 7, and a second interlayer dielectric film 8 are formed sequentially (Fig. 9(b) on the N-type semiconductor substrate 1.

Smoothing heat treatment is conducted at 900°C or higher in a nitrogen (n₂) atmosphere. As a result of the heat treatment, the interlayer dielectric film 8 is smoothed. Hence, in the convex part of the matrix, the film thickness of the interlayer dielectric film 8 decreases. For example, in the shoulder part A of the step where the first light-shield film 7 is formed, the interlayer dielectric film 8 is extremely thin (Fig. 9 (c)).

Next, a contact hole 9 is opened by plasma etching. Then, in a gas containing phosphorus in its composition, for example, in an atmosphere of phosphine (PH₃) or the like, heat treatment is conducted at 900°C or higher, and a phosphorus glass film (P₂O₅ film) (not shown) is formed over the entire surface. At the same time, phosphorus from this phosphorus glass film, is diffused thermally into the N-type semiconductor substrate 1. In this way, the N-type diffusion layer is formed as a layer 10.

Subsequently, using a 20:1 by mol solution of water and hydrofluoric acid, the phosphorus glass film is removed by wet etching. In this wet etching, the chemical solution is hardly circulated in the bottom of the fine contact hole. Hence, sufficient overetching is done to ensure that no phosphorus glass remains. When using the solution, an etching time of about 20 seconds is required. In the region where the circulation of the solution is promoted smoothly, the phosphorus glass film is removed promptly, so that the interlayer dielectric film 8 is also etched (Fig. 9 (d)).

Next, an aluminium film is deposited by sputtering onto the entire substrate surface to a thickness of 1 µm. Then, using the resist pattern (not shown) as a mask, plasma etching is effected to form a wiring layer 11 and a second light-shield film 12. Lastly, on the uppermost surface of the device, a silicon dioxide film (SiO₂ film) is formed by the plasma enhanced CVD method as a final protective film 13.

In such prior art devices, however, if the interlayer dielectric film 8 is thick, the aspect ratio of the contact hole 9 formed therein is large. Hence, it is difficult to etch adequately. Besides, because of the large aspect ratio, a step is formed in the wiring layer 11 over the contact hole 9. The same phenomenon occurs not only in the solid-state image pickup device, but also in other semiconductor devices.

An intrinsic problem of the solid-state image pickup device, moreover, is that, if the interlayer dielectric film 8 is thick, light enters the first light-shield film 7 obliquely from the interlayer dielectric film 8. Since the first light-shield film 7 has a thickness consistent with processability, some of the light penetrates through the first light-shield film 7, thereby deteriorating the smear noise characteristic of the CCD solid-state image pickup device.

However, when it is attempted to apply the structure of the conventional semiconductor devices and their manufacturing methods to solid-state image pickup devices, the interlayer dielectric film 8, must be thick initially, if a satisfactory breakdown voltage is to be achieved because of the decrease in the film thickness in the convex part of the matrix caused by the smoothing process.

Generally, these are large fluctuations in etching rate when wet etching is practised, and hence a large variation occurs in the thinning of the interlayer dielectric film 8 from overetching during removal of the phosphorus glass film. The film thickness of the interlayer dielectric film 8 varies in a range of about 20 to 40 nm across a wafer, between wafers, and between lots. As a result of such fluctuations in film thickness and the necessity of obtaining a specific interlayer dielectric breakdown voltage, it is more difficult to form a thin interlayer dielectric film 8.

The invention relates to a semiconductor device solving such problems of thinning of the interlayer dielectric film.

A conventional solid-state image pick-up device is described in US-A-5028972.

To solve the above problems a device according to the present invention is characterised in that the interlayer dielectric film comprises a multiple-layer film of at least a first interlayer dielectric film and a second interlayer dielectric film, said second interlayer dielectric film is of a material having a lower etching rate than that of said first interlayer dielectric film for the same etchant, and the second interlayer dielectric film is formed beneath the first interlayer dielectric film.

A method according to the present invention is characterised in that said interlayer dielectric film comprises first and second interlayer dielectric films and is formed by forming the second interlayer dielectric film on said first light shield film and thereafter forming the first interlayer dielectric film on said second interlayer dielectric film, said second interlayer dielectric film being formed of a material having a lower etching rate than that of said first interlayer dielectric film for the same etchant.

According to the structure of semiconductor device and the manufacturing method of the invention, if the first interlayer dielectric film is eliminated during etching and the etching exposes the second interlayer dielectric film, the second interlayer dielectric film is hardly thinned, and therefore the second interlayer dielectric film is formed in a film thickness having a specific dielectric breakdown voltage, so that a film thickness consistent with the required interlayer dielectric breakdown voltage is not needed in the first interlayer dielectric film. Hence, a thin film having a desired smooth shape may be formed. Consequently, the smear noise characteristic may be notably improved in a solid-state image pickup device embodying the invention.

An embodiment of the present invention will now be described, by way of, example, with reference to Figs. 1 to 7 of the accompanying drawings in which:-

Fig. 1 is a plan view of an embodiment of a solid-state image pickup device of the invention.

Fig. 2 is a sectional view of an embodiment of a solid-state image pickup device of the invention.

Fig. 3 is a process sectional diagram of an embodiment of manufacturing method of a solid-state image pickup device of the invention.

Fig. 4 is a process sectional diagram of an embodiment of manufacturing method of a solid-state image pickup device of the invention.

Fig. 5 is process sectional diagram of an embodiment of manufacturing method of a solid-state image pickup device of the invention.

Fig. 6 is a process sectional diagram of an embodiment of manufacturing method of a solid-state image pickup device of the invention.

Fig. 7 is a process sectional diagram of an embodiment of manufacturing method of a solid-state image pickup device of the invention.

Fig. 8 is sectional view of a conventional solid-state image pickup device.

Fig. 9 is a process sectional view of manufacturing method of a conventional solid-state image pickup device.

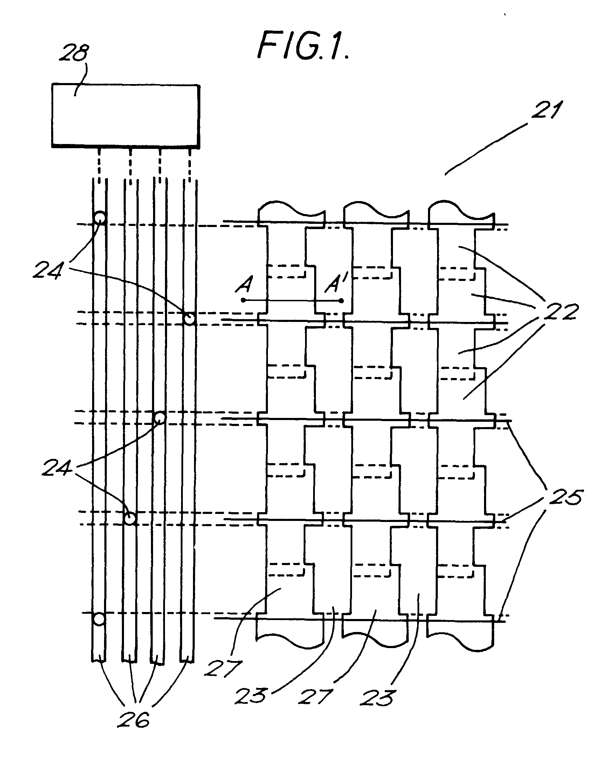

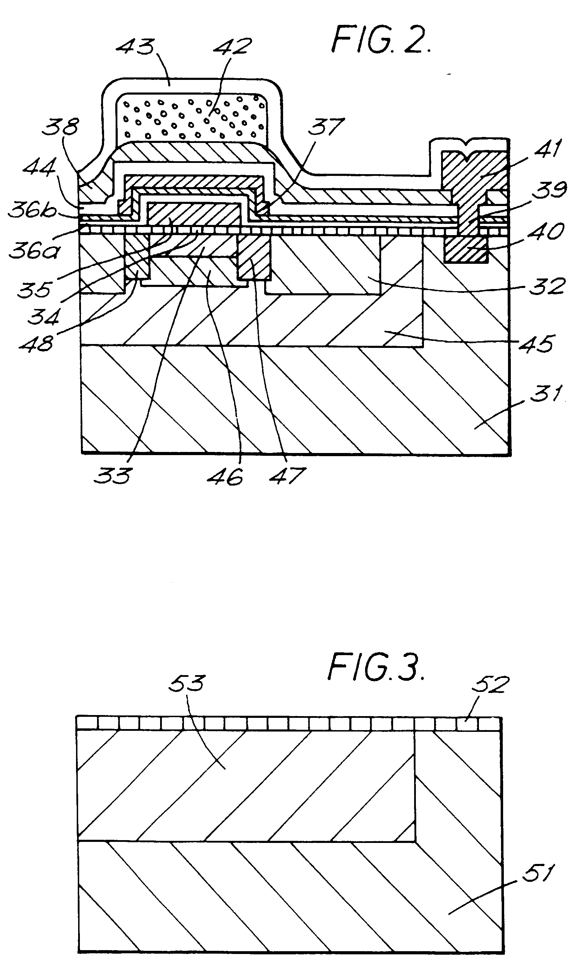

Referring to Figs. 1 and 2, a transfer gate electrode 22 is formed on a N-type semiconductor substrate 21. The transfer gate electrode 22 comprises a first transfer gate electrode portion and a second transfer gate electrode portion. The transfer gate electrode 22 is disposed linearly in the vertical direction of the sheet of paper on either side of an interlayer dielectric film 25.

A photodiode 23 is formed adjacent to the transfer gate electrode 22. That is, in the lateral direction on the sheet of paper, the transfer gate electrode 22 and the photodiode 23 make up a pair, and this pair is disposed linearly in the lateral direction. In this way, the transfer gate electrodes 22 and photodiodes 23 are formed in a matrix on the N-type semiconductor substrate 21. One pitch in the image pickup region comprises one photodiode 23 and its adjacent transfer gate electrode 22. Thus, the size of the unit cell, which is one pitch in the image pickup region, is about 6 µm x about 6 µm.

The solid-state image pickup device in Fig. 1 is put in operation when a four-phase pulse driving signal is applied to the transfer gate electrodes 22. The transfer gate electrodes 22 are electrically connected to their neighbours in the lateral direction to form a transfer gate electrode group.

An interlayer film (not shown) is formed on the surface of the transfer gate electrode 22, and the transfer gate electrode 22 is electrically insulated from a light-shield film 27 and a wiring layer 28. A contact hole 24 is formed by etching and removing the interlayer film at the lefthand side of the transfer gate electrode group. The dimension of the contact hole 24 in the vertical direction on the sheet of paper is about 1 µm.

The transfer gate electrode 22 is connected to the wiring layer 26 through the contact hole 24. Four wiring layers 26 are provided, one for each phase of the four-phase pulse driving signal. The transfer gate electrode group consists of a set of four transfer gate electrodes 22 each comprising two transfer gate electrode portions which overlap in the vertical direction on the sheet of paper, and are on either side of the interlayer dielectric film 25.

Driving pulses of different phases are applied from the wiring layer 26. The driving pulses are supplied to the transfer gate electrode group through the wiring layer 26 from a pulse driving circuit 28. The driving pulses generate three signal potentials; high (H), medium (M), and low (L). In this embodiment, they are respectively 15 V, 0 V, and -7 V. Although not shown in the drawings, a similar arrangement of contact holes, wiring, and driving circuit is disposed to the right of the transfer gate electrode groups, and driving pulses, the same as those supplied from the driving circuit 28, are supplied. In this way, by feeding driving pulses from both sides of the transfer gate electrode groups, the waveform of the driving pulse is prevented from distorting as the driving pulses propagate through the transfer gate electrodes 22, thereby avoiding deterioration of the transfer efficiency.

A light-shield film 27 is formed on each transfer gate electrode 22 through a dielectric film. The light-shield films 27 prevent light from entering form outside into the transfer channel (not shown) which is an N-type diffusion-layer formed in the N-type semiconductor substrate 21 beneath the transfer gate electrode 22. In the vertical direction on the sheet of paper, the transfer gate electrode portions overlap because another transfer gate electrode portion is formed on another transfer gate electrode portion by self-alignment in the manufacture of the transfer gate electrodes 22. The shape of the transfer gate electrode 22 is formed over a wider area in the upper transfer gate electrode portion than is the lower one. This is because the electric charge generated in the photodiode 23 is read out into the transfer channel, formed in the N-type semiconductor substrate 21 beneath the transfer gate 22, by the transfer gate electrode portion formed above the dielectric film 25.

Hence, in order to pickup the electric charge generated in the photodiode 23 more easily, the transfer gate electrode 22 responsible for pickup is placed closer to the photodiode 23. For this reason, the area of the transfer gate electrode 22 differs on the opposite sides of the dielectric film 26.

In such a solid-state image pickup device, the signal charge can be read out from the photodiode 23 to the transfer channel by applying 15 V to the upper transfer gate electrode 22 having a wider area. Consequently, by applying four-phase driving pulses alternately repeating O V and -7 V to the transfer gate electrodes 22, the signal charges read out in the transfer channels can be sequentially transferred to the specified output position.

Referring specifically to Fig. 2, the N-type semiconductor substrate 31 has a plan azimuth of (100), and its impurity concentration is about 10¹⁴ cm⁻³. On the N-type semiconductor substrate 31, a first P type diffusion layer 45 is formed. The depth of the first P-type diffusion layer 45 is about 5 µm. The impurity concentration of the first P-type diffusion layer 45 is about 10¹⁵ cm⁻³. The first P-type diffusion layer 45 is provided in order to discharge overflow charge in the photodiode 32. That is, the photodiode 32 is formed as an N-type diffusion layer on an N-type semiconductor substrate 31. In the photodiode 32, an electric charge (photocarrier) is formed by incident photons, and it is temporarily stored inside. If more charge is accumulated than can be stored in the photodiode 32, it flows into another region from the photodiode 32. When such electric charge enters a transfer channel 33, it may cause blooming. The occurrence of blooming may be prevented by forming a first P-type diffusion layer 45. The first P-type diffusion layer 45 is fixed at zero volts. Hence, due to the potential distribution in these regions, the electric charge generated in the photodiode 32 is discharged into the N-type semiconductor substrate 31 through the first P-type diffusion layer 45. By setting the impurity concentration of the first P-type diffusion layer 45 at the specified value, the photodiode 32 may be easily depleted when the solid-state image pickup device operates, and the quantity of the signal charge may increase. The depth of the first P-type diffusion layer 45 is determined by the depth of the photodiode 32 and the breakdown voltage between the two. The depth of the photodiode 32 is required to be about 2 µm in order to obtain a sufficient photoelectric conversion efficiency when light in the visible region of the spectrum enters.

In the first P-type diffusion layer 45, an N-type diffusion layer is formed as a photodiode 32. When light enters the photodiode 32, a carrier pair comprising an electron and a hole is generated in the depletion layer of the photodiode 32. The electron becomes a signal charge through the adjacent transfer channel 33. The hole is taken out of the N-type semiconductor substrate 31 through the first P-type diffusion layer 45. In this way, the photodiode 32 converts incident light into signal charges. The impurity concentration of the photodiode 32 is about 10¹⁶ cm⁻³. Inside the first P-type diffusion layer 45, a second P-type diffusion layer 46 is formed. The second P-type diffusion layer 46 prevents the generation of noise by preventing the signals generated in the N-type semiconductor substrate 31 from diffusing into the transfer channel 33. The diffusion depth of the second P-type diffusion layer 46 is about 1 µm. The impurity concentration of the second P-type diffusion layer 46 is 10¹⁶ cm⁻³.

The second P-type diffusion layer 46 is used for enclosing the transfer channel 33. Such a structure is known as a Hi-C structure. When the diffusion depth of the second diffusion layer 46 is increased by heat treatment, diffusion in the lateral direction is promoted at the same time. Hence, the second P-type diffusion layer 46 expands up to the N-type diffusion layer of the photodiode 32. When the second diffusion layer 46 invades into the photodiode 32, the photoelectric conversion output is lowered. The transfer channel 33 transfers the signal charge formed in the photodiode 32 into a specific region.

The diffusion depth of the transfer channel 33 is about 0.5 µm. The impurity concentration of the transfer channel 33 is 10¹⁶ to 10¹⁷ cm⁻³.

To realize the Hi-C structure, the second P-type diffusion layer 46 must be wider than the transfer channel 33.

When reading out the signal charge, generated in the photodiode 32, into the transfer channel 33, the potential of the transfer channel 33 is set lower than the potential of the photodiode 32. When the signal charge conveyed to the transfer channel 33 flows back to the photodiode 32 or the signal charge is present in the transfer channel 33, the signal charge formed in the photodiode 32 must be prevented from flowing into the transfer channel 33. Accordingly, a third P-type diffusion layer 47 for controlling the potential during reading out is formed between the photodiode 32 and the transfer channel 33. If a signal charge is transferred from the photodiode 32 to the transfer channel 33, the potential in the third P-type diffusion layer 47 is controlled so as to be lower than the potential of the photodiode 32, and the same as or slightly higher than the potential of the transfer channel 33. When the signal charge is accumulated in the transfer channel 33, the potential of the third P-type diffusion layer 47 is controlled to be higher than the potential of the photodiode 32, and higher than the potential of the transfer channel 33 in order that the signal charge may not flow back into the photodiode 32.

The diffusion layer depth of the third P-type diffusion layer 47 is about 1µm. The surface impurity concentration of the third P-type diffusion layer 47 on the semiconductor substrate surface is 10¹⁶ to 10¹⁷ cm⁻³.

When the voltage of the driving pulse for operating the solid-state image pickup device is zero volts or 15 V, it is necessary to prevent the signal charge from flowing back from the transfer channel 33 into the photodiode 32, or to cause the signal charge to flow from the photodiode 32 into the transfer channel 33. In order to achieve the threshold voltage capable of maintaining an optimum potential distribution in each state, the diffusion layer depth of the third P-type diffusion layer 47 and the impurity concentration are defined. The width of the third P-type diffusion layer 47 should be preferably about 1µm or less. If the width of the third P-type diffusion layer 47 is more than 1µm, the gm characteristic of the transistor is impaired. As the gm characteristic worsens, it is impossible to read out the signal charge accumulated in the photodiode 32 completely. On the contrary, if the width of the third P-type diffusion layer 47 is less than about 1 µm, a short channel effect takes place. Consequently, punch-through is likely to occur. As a result, the photoelectric conversion output of the photodiode 32 becomes lower.

In the solid-state image pickup device, photodiode 32 and transfer channel 33 constitute pairs, and are formed in a matrix. To separate adjacent pairs electrically, a fourth P-type diffusion layer 48 is formed. The fourth P-type diffusion layer 48 is formed by ion implantation. The depth of the fourth P-type diffusion layer 48 is about 1µm. The surface impurity concentration of the fourth P-type diffusion layer 48 is 10¹⁷ to 10¹⁸ cm⁻³.

The surface impurity concentration of the fourth P-type diffusion layer 48 must be set in the above range in order that the signal charge accumulated in the adjacent photodiode 32 may not flow in. If the surface impurity concentration is less than 10¹⁷ cm⁻³, the signal charge of the adjacent photodiode 32 flows in. If the surface impurity concentration is more than 10¹⁸ cm⁻³, a narrow channel effect occurs in the adjacent transfer channel 33. As a result of the narrow channel effect, the transfer capacity of the transfer channel 33 is lowered. Hence, the dynamic range of the solid-state image pickup device is reduced, and the transfer efficiency is impaired.

The width of the fourth P-type diffusion layer 48 should be about 1 µm or less. If the width of the fourth P-type diffusion layer 48 is larger than 1µm, the transfer region of the transfer channel 33 decreases. That is, the signal charge accumulated in the photodiode 32 cannot be read out completely. Conversely, if the width of the fourth P-type diffusion layer 48 is less than 1µm a short channel effect occurs. Consequently, punch-through is likely to occur between the adjacent photodiode 32 and transfer channel 33. As a result, when reading out the information in the adjacent photodiode 32, the resolution is lowered. Furthermore, the output of the photodiode 32 is lowered.

On the N-type semiconductor substrate 31, a silicon dioxide gate dielectric film 34 is grown. The gate dielectric film 34 is formed by the pyrogenic oxidation method. The thickness of the gate dielectric film 34 is preferably 50 nm or more in order to raise the transfer efficiency by utilizing the fringing effect.

The transfer gate electrode 35 is formed by patterning polysilicon grown by the low pressure CVD method. The sheet resistance of the transfer gate electrode 35 is scores of ohms. The film thickness of the transfer gate electrode 35 is about 500 nm. The transfer gate electrode 35 is used as an electrode for applying a driving pulse for transferring the signal charge formed by the photodiode 32 into the transfer channel 33. Thus, the transfer gate electrode 35 is desired to have as a low resistance as possible. However, if the phosphorus doping is increased for the purpose of lowering the resistance, the surface of the transfer gate electrode 35 is oxidized, and the breakdown voltage of the interlayer film 36a deteriorates, and hence the phosphorus doping should be preferably in the amount specified above. An interlayer film 36a composed of polysilicon oxide film is grown on the surface of the transfer gate electrode 35.

The interlayer film 36a is grown by oxidizing the surface of the transfer gate electrode 35 by the pyrogenic oxidation process. The thickness of the interlayer film 36a is about 200 nm. The interlayer film 36a is formed so as to maintain the breakdown voltage. Due to the etching residue of the polysilicon film created by the etching carried out during formation of the transfer gate electrode 35, when a driving voltage is applied, leakage occurs through the etching residue on the polysilicon film. By burning out the etching residue of polysilicon when forming the interlayer film 36a, leakage may be prevented. Since the four-phase driving pulses applied to the transfer gate electrode 35 change in level, e.g. -7V, 0V, and + 15 V, the interlayer film 36b has a breakdown voltage greater than the maximum differential voltage, i.e. 22 V.

The interlayer film 36b is formed by a polysilicon oxide film on the surface of the interlayer film 36a. The thickness of the interlayer film 36b is about 100 nm. The interlayer film 36b is formed by the CVD method. The interlayer film 36b is formed in order to prevent local lowering of the breakdown voltage due to pin holes or the like in the interlayer film 36a. To decrease the amount of etching residue produced during etching of the first light-shield film 37, it is necessary to improve the step coverage in the interlayer film 36b. The low pressure CVD method is more appropriate than the atmosphere pressure CVD method for growing the interlayer film 36b. The thicker the interlayer film 36b, the greater the gap between the first light-shield film 37 and the N-type semiconductor substrate 31, light entering the transfer channel 33 obliquely increases, thereby increasing the smear noise. It is undesirable for the interlayer film 36b to exceed the specified thickness by a significant amount.

In order to prevent light from entering the transfer channel 33 and generate smear noise, the first light-shield film 37 is formed. In the invention, the first light-shield film 37 comprises a tungsten polycide film formed by stacking up a polysilicon film and a tungsten silicide film. The polysilicon film forming the lower layer of the first light-shield film 37 (hereinafter called the lower polysilicon film) is grown by the low pressure CVD method. The thickness of the lower polysilicon film is about 100 nm. This thickness is determined to relieve the stress between the interlayer film 36b of the base and the tungsten silicide film forming the upper layer of the first light-shield film 37 (hereinafter called the upper tungsten silicide film), and prevent the upper silicide film peeling off. In order to reduce smear noise (enhancement of light-shield characteristic of the tungsten silicide film), it is necessary to increase the thickness of the tungsten silicide film, but considering the processability of the tungsten silicide film in the subsequent steps and prevention of peeling of the film, the film thickness is defined at 200 nm. At the thickness of 200 nm, the transmissivity for visible light is about 0.01% and this film thickness is free from problems when used as a light-shield film. The upper tungsten silicide film may be formed by the sputtering method, but preferably in order that its thickness is not reduced in the step portion of the transfer gate electrode 35 to deteriorating the light-shield characteristic, it is better to use the CVD method which produces excellent coverage. The photocarriers caused by the light entering the transfer channel 33 become smear noise components. The first light-shield film 37 is formed in order to prevent penetration of light into the transfer channel 33 to avoid generation of smear noise. The first light-shield film 37 is formed on the interlayer film 36b, and is formed so as to cover the transfer gate electrode 35 and have an opening above the photodiode 32. The positional relationship between the end of the first light-shield film 37 and the end of the photodiode 32 is the result of a trade-off between the smear noise characteristic and the sensitivity of the solid-state image pickup device. When the end portion of the first light-shield film 37 projects over the photodiode 32, the light incident on the photodiode 32 decreases, and hence the sensitivity drops, whereas the light incident on the transfer channel 33 decreases, thereby reducing the smear noise. If the end of the first light-shield film 37 does not reach the vicinity of the end of the photodiode 32, the smear noise characteristic deteriorates without an improvement in sensitivity. As shown in Fig. 2, the end portion of the first light-shield film 37 should, preferably, at least reach the vicinity of the end of the photodiode 32.

On the first light-shield film 37 and on the interlayer film 36b in the opening in the first light-shield film 37, a second interlayer dielectric film 44, composed of a silicon dioxide film, is provided. The second interlayer dielectric film 44 is grown by the low pressure CVD method or the atmosphere pressure CVD method. The thickness of the second interlayer dielectric film 44 is 200 nm. This thickness is determined so as to achieve the following two purposes even by the second interlayer dielectric film 44 alone. The first purpose is to form a buffer layer which prevents etching damage, during dry etching for patterning the second light-shield film 42, from causing crystal defects in the photodiode 32. In the embodiment, since a silicone-containing aluminium film is used as the second light-shield film, heat treatment at about 900°C for recovering from such etching damage cannot be performed generally. Such crystal defects in the photodiode 32 induce a serious problem, appearing on the image screen as a white blemish. The second purpose is to keep a specific dielectric breakdown voltage between the transfer gate electrode 35 and the wiring layer including the first light-shield film 37, second light-shield film 42 and wiring layer 41. In the case of the solid-state image pickup device of the embodiment, the second interlayer dielectric film 44 requires a breakdown voltage of about 30 V. On the other hand, to achieve these two purposes, the thickness of the second interlayer dielectric film 44 must be increased, but this approach is not recommended. That is, light entering the first light-shield film 37 obliquely through the second interlayer dielectric film 44 increases. When the intensity of this obliquely incident light is high, some of the light passes through the first light-shield film 37 to cause smear noise. The smear noise characteristic is a particularly important characteristic of a solid-state image pickup device, and hence it is necessary to keep smear noise as low as possible, and it is not appropriate to increase the thickness of the second interlayer film 44.

A first interlayer dielectric film 38 of boron phosphosilicate glass (BPSG) film is formed on the second interlayer dielectric film 44. The first interlayer dielectric film 38 is built up by the atmosphere pressure CVD method. The first interlayer dielectric film 38 is grown to a thickness of 600 nm, this thickness is the thickness in a flat region. Due to the poorness of the step coverage obtained by the atmosphere pressure CVD method, the film thickness is thinner in the region where the uppermost surface has a concave form. For example, on the second interlayer dielectric film 44 above the photodiode 32, the growth is only about 400 nm in the thinnest portion. The first interlayer dielectric film 38 is smoothed on the uppermost surface by heat treatment at 900°C in a N₂ atmosphere. The BPSG film composing the first interlayer dielectric film 38 contains boron and phosphorus by about 3 wt.% and about wt.% respectively, when being built up. The higher the concentrations of boron and phosphorus in the BPSG film, the greater is the smoothing effect on the uppermost surface during smoothing heat treatment, but boron and phosphorus may diffuse externally from the film during the smoothing heat treatment, and react in the vapor phase to produce granular foreign matter on the BPSG film surface. Therefore, the boron and phosphorus concentrations in the first interlayer dielectric film 38 should be preferably controlled below the specified values. On the other hand, the boron and phosphorus concentrations may be lower than specified, but in this case, the smoothing of the uppermost surface of the first interlayer dielectric film 38 deteriorates. The concentrations of boron and phosphorus may be lowered to a range satisfying the following smoothing requirements. The smoothed shape particularly depends on the boron concentration, and the lower limit is about 1.2 wt.% in this embodiment. The smoothed shape may be improved by increasing the thickness of the first interlayer dielectric film 38, but as in the case of the second interlayer dielectric film 44, it is not desirable to increase the film thickness from the viewpoint of the smear noise characteristic.

Smoothing of the uppermost surface of the first interlayer dielectric film 33 is intended to ensure that the second light-shield film 42 has satisfactory covering properties is free of cracks, and to reduce the overetching in the dry etching step. The less smooth is the uppermost surface of the first interlayer dielectric film 38, the more overetching is required. This causes an increase in white blemishes resulting from more etching damage to the photodiode 32. In the structure of the solid-state image pickup device of the embodiment, the maximum gradient of the uppermost surface of the first interlayer dielectric film 38 is about 70 degrees, and the overetching time for the necessary etching in the flat region of the solid-state image pickup device my be enough at about 60% under the same etching conditions, and etching without etching residue and generation of white blemishes may be achieved. The steeper the gradient, the more overetching is required, which is likely to cause white blemishes. The uppermost surface of the first interlayer dielectric film 33 should not overhang.

The first interlayer dielectric film 38 is built up to a thickness of 60 nm, but it is thinner than this in the step portion of the base level due to viscous fluidity at the time of the smoothing treatment. For example, in the shoulder part of the first light-shield film 37 after smoothing heat treatment, the thickness of the first interlayer dielectric film 38 is about 300 nm.

In the sectional view of the solid-state image pickup device shown in Fig. 2 in the shoulder part of the first light-shield film 37, the first interlayer dielectric film 38 is eliminated, and the second light-shield film 42 and the second interlayer dielectric film 44 contact each other. This is due to the following reason. In the manufacturing process of the solid-state image pickup device, by etching on the uppermost surface of the first interlayer dielectric film 38, film thickness decreases. The relation between this etching and first interlayer dielectric film 38 thickness reduction is described in detail below.

A second light-shield film 42 is formed on the first interlayer dielectric film 38 above the first light-shield film 37. The second light-shield film 42 is composed of an aluminium film containing 1% of silicon. The use of a silicon-containing aluminium film as the second light-shield film 42 is so that it can be formed in the same film forming and etching steps as the wiring layer 41, thereby simplifying the overall process. When the second light-shield film 42 is formed by different film forming and etching steps from the wiring layer 41, for example, pure aluminium may be used. In this case, the problem of the increase in light transmissivity due to silicon nodules, noted when heat treatment is applied to the silicon containing aluminium, may be avoided. The film thickness of the silicon containing aluminium for forming the second light-shield film 42 is 1 µm. At this film thickness, the light transmissivity of the second light-shield film 42 is 0.01%, and a sufficient light-shield characteristic is achieved for practical purposes. Whereas the first light-shield film 37 is effective to prevent incidence of light from an oblique direction on the transfer channel 33, the second light-shield film 42 is provided mainly in order to prevent incidence of intense light from the vertical direction on the transfer channel 33 through the first light-shield film 37. The second light-shield film 42 at least covers entirely the transfer channel 33. The end portion of the second light-shield film 42 should preferably not project over the photodiode 32 beyond the end of the first light-shield film 37 so as not to lower the sensitivity of the photodiode 32.

The contact hole 39 is opened by etching and removing the gate dielectric film 34, the interlayer film 36a, the interlayer film 36b, the second interlayer dielectric film 44 and the first interlayer dielectric film 38. The contact hole 39 is present in the peripheral parts of the solid-state image pickup device, and the geometrical relation with the image pickup region of the solid-state image pickup device is not critical. Fig. 2 shows it close to the image pickup region of the solid-state image pickup device for the sake of convenience. The size of the contact hole 39 is about 5 µm x about 5 µm. Although not shown in Fig. 2, the minimum diameter of the contact holes provided for applying driving pulses to the transfer gate electrode 35 is about 1 µm, and they are opened by etching and removing the interlayer film 36a, the interlayer film 36b, the second interlayer dielectric film 44 and the first interlayer dielectric film 38.

At the bottom of the contact hole 39, an N-type diffusion layer 40, formed by thermally diffusing phosphorus, is present. The N-type diffusion layer 40 is formed by heat treatment after opening of the contact hole 39 in a phosphorus-containing atmosphere such as POCL₃ or PH₃. The N-type diffusion layer 40 is formed in order to obtain an ohmic contact between the wiring layer 41 and the N-type semiconductor substrate 31. The sheet resistance of the N-type diffusion layer 40 is about 5 to 10 Ω/□. The N-type diffusion layer 41 is about 2 µm deep.

The wiring layer 41 is composed of aluminium containing silicon. The silicon content of the wiring layer 41 is about 1%. The thickness of the wiring layer 41 is about 1 µm. The wiring layer 41 is connected to the N-type semiconductor substrate 31 through the contact hole 39, and a voltage is applied. A voltage of about 10 V is applied to be N-type semiconductor substrate 31, and the photocarriers generated in the photodiode 32 are led into the N-type semiconductor substrate 31 so as not to escape into the transfer channel 33. At the time of a vertical withdrawing action, a voltage of about 30 V is applied to the N-type semiconductor substrate 31. The vertical withdrawing action is to withdraw all photocarriers, accumulated in the photodiode 32, by force into the N-type semiconductor substrate 31 by applying a voltage of about 30 V to the N-type semiconductor substrate 31, which is, so to speak, the shutter action of the solid-state image pickup device.

On the uppermost surface of the solid-state image pickup device, a final silicondioxide protective film 43 is formed by the plasma enhanced CVD method. The thickness of the final protective film 43 is 400 nm. The final protective film 43 protects the uppermost surface of the solid-state image pickup device from, for example, invasion by mobile ions from outside.

The operation of such a solid-state image pickup device will now be described. Light enters the photodiode 32, formed in the N-type semiconductor substrate 31 from outside. In the photodiode 32, photoelectric conversion takes place, and photocarriers are generated and accumulated in dependence on the number of photons reaching the photodiode 32. In this state, when a voltage pulse of + 15 V is applied to the transfer gate electrode 35, the photocarriers are read out into the transfer channel 33. Next, voltage pulses, alternately repeating voltages of 0 V and -7 V, are applied to the transfer gate electrode 35, and the photocarriers inside the transfer channel 33 are transferred to the specified output unit. Voltages are applied to the first light-shield film 37 and the second light-shield film 42.

A voltage from the wiring layer 41 is applied to the N-type semiconductor substrate 31. Usually, a voltage of about 10 V is applied, and photocarriers overflowing from the photodiode 32 are drawn into the N-type semiconductor substrate 31, consequently not flowing into the transfer channel 33. At the time of the "shutter action", a voltage of about 30 V is applied. This is intended to effect the shutter action of the solid-state image pickup device by withdrawing all of the photocarriers accumulated inside the photodiode 32 into the N-type semiconductor substrate 31.

In the solid-state image pickup device in the described embodiment of the invention, an interlayer dielectric film is composed of a first interlayer dielectric film 38 and a second interlayer dielectric film 44 stacked thereon. In the specified etching, the etchment is selected to have an etching rate for the second interlayer dielectric film 44 which is significantly slower than that for the first interlayer dielectric film 38. In the solid-state image pickup device having such a constitution, after the specified etching, if the first interlayer dielectric film 38 is eliminated in a portion thinned by smoothing treatment, and this specified etching reaches the second interlayer dielectric film 44, there is hardly any etching of the second interlayer dielectric film 44. Owing to this effect, a high quality and stable yield is obtained.

In the manufacturing process of the solid-state image pickup device, etching is executed on the uppermost surface of the first interlayer dielectric film 38 after smoothing heat treatment. This etching is described below and is executed before the second light-shield film 42 is formed. The N-type diffusion layer 40 is formed by solid phase diffusion of phosphorus from the phosphorus glass (P₂O₅ film (not shown) grown over the entire surface of the solid-state image pickup device. This phosphorus glass film is unnecessary after the N-type diffusion film 41 is formed, and therefore it is removed by wet etching using a mixed solution of water (H₂O) and hydrofluoric acid (HF). The mixing ratio of water:hydrofluoric acid is 20:1. This mixing ratio is established to balance the controllability of the etching rate and the through-put. The thickness of the phosphorus glass film, to be grown, is about 50 nm or less, and it is difficult to accurately measure the etching rate using this chemical solution. For example, however, to completely remove this phosphorus glass film in a slow circulation region of the chemical solution, such as the contact hole of the transfer gate electrode 35 with a minimum diameter 1 µm (aspect ratio about 1) in the solid-state image pickup device, it is known that about 20 seconds is appropriate allowing for the effects of variations between lots and the variations due to fatigue of the chemical solution. On the other hand, the etching rate of this chemical solution on the BPSG film of the first interlayer dielectric film 38 and the silicon dioxide film for the second interlayer dielectric film 44 is respectively 450 nm/min and 30 nm/min. It is, however, confirmed that diffusion of phosphorus from the phoshorus glass film occurs on the first interlayer dielectric film 38 from the phosphorus glass film from the surface to a depth of about 200 nm, and that the average etching rate in this region is increased to about 1000 nm/min.

The wet etching is generally a batch process in which a plurality of semiconductor substrates, contained in a cassette, is placed a circulating chemical solution tank filled with a particular etching solution. This method uses inexpensive apparatus, but the controllability is poor at the start point and end point of etching, and the chemical solution fatigues when the etching process is repeated. Besides, the circulation of the chemical solution depends on the number of pieces and the arrangement of the semiconductor substrates. It is also known that very many factors are known to affect the etching rate. These factors cause significant fluctuations in the film thickness reduction when the etching time is short, in particular. In addition, the phosphorus diffusion layer extending from the surface of the first interlayer dielectric film 38 to a depth of 20 nm also causes the film thickness reduction to vary. The thickness reduction of the first interlayer dielectric film 38 by wet etching always occurs in a range of 200 to 400 nm if the fluctuations are controlled well. In particular, individual differences occur in the etching time when charging and discharging of the chemical solution are done manually by different workers. Hence, the fluctuations in film thickness reduction are further expanded. In a swollen portion of the base material such as the shoulder of the first light-shield film 37, the thickness of the first interlayer dielectric film 38 is decreased to 300 nm by the smoothing heat treatment. If, therefore, the film reduction is biased to the larger side, it is etched and removed as shown in Fig. 2, and the second interlayer dielectric film 44 is exposed. Or, in the case of a dent in the base material, for example, above the photodiode 32, in the thinner region of the first interlayer dielectric film 38 from the beginning of stacking, the second interlayer dielectric film 44 is also exposed. If etching reaches the second interlayer dielectric film 44, its film thickness reduction is very small. That is, since the etching rate of the silicon dioxide film, forming the second interlayer dielectric film 44, is 30 nm/min, the film thickness reduction in the region exposed by etching is less than 10 nm. Thus, the second interlayer dielectric film 44 plays the role of a stopper for etching. As mentioned above, the second dielectric film 44 is effective to keep the interlayer dielectric breakdown voltage and play the role of etching damage buffer layer. Hence, it is no problem if the first interlayer dielectric film 38 is eliminated in the thin area.

On the other hand, from the swollen part of a step in the base material, a viscous fluid film flows in, and the film thickness increases in the first interlayer dielectric film 38. The first interlayer dielectric film 38 will not disappear if the fluctuations of the film thickness are within the above range. As a result, the smoothed shaped of the uppermost surface of the first interlayer dielectric film 38 is hardly deteriorated, and the overetching time is not extended at least to the occurrence of deterioration of or cracks in the step coverage portion of the second light-shield film 42, or etching of the second light-shield film 42.

In a conventional solid-state image pickup device, the following problems were experienced. In a solid-state image pickup device, hitherto, the interlayer dielectric film intervening between the first light-shield film 37 and the second light-shield film 42 is composed of a BPSG film (hereinafter called interlayer BPSG film). To solve the problems of interlayer dielectric breakdown voltage and etching damage buffer, the thickness of the interlayer BPSG film is required to be at least 200 nm, and the stacking condition for obtaining this film thickness is the thickness of 900 nm. This film thickness is a figure estimated from the fact that the film thickness decreases in the base swollen part by smoothing and that the film reduction due to etching and removing of the phosphorus glass film is 400 nm at maximum in the case of favourable controllability. Actually, in the production of products, the margin, considering the variations due to differences between workers in the working procedure, should be settled within the film thickness, and a further greater film thickness is needed seeing that the etching rate of the interlayer BPSG film is relatively fast at 450 nm/min. Considering also the film thickness fluctuations of stacking up in the interlayer BPSG film, the stacking film thickness must be more than 1100 nm.

Generally, however, when growing the BPSG film using the atmosphere pressure CVD method, the particles generated by the vapor phase reaction increase with the increasing film thickness, thereby lowering the yield. Meanwhile, the contact hole, opened by etching and removing the interlayer BPSG film, is processed by reactive ion etching using a fluorohydrocarbon gas, such as CHF₃ as the etching gas, but it is empirically know that an abnormal deposition is likely to occur in the etching region with the increase in the thickness of the BPSG film. This abnormal deposition is a polymer grown mainly from carbon and fluorine, and it is a trouble often found in BPSG films, in particular, but no other detail has been unveiled, but anyway it is one of the factors lowering the yield.

Besides, as mentioned above, if the thickness is increased in the interlayer dielectric film between the first light-shield film 37 and second light-shield film 42, the smear noise characteristic of the solid-state image pickup device deteriorates. In the conventional constitution of the solid-state image pickup device, when produced by defining the film thickness upon growth of the interlayer BPSG film at a minimum limit of 900 nm, those obtained, which conform regarding the interlayer dielectric breakdown voltage, are formed in the same interlayer dielectric film of the first interlayer dielectric film 38 and second interlayer dielectric film 44 of the solid-state image pickup device in the structure of the embodiment, and a similar smear noise value is obtained, but the yield has been lowered due to the occurrence of failure of the interlayer. breakdown voltage and white blemishes.

By contrast, in the solid-state image pickup device conforming to the invention, the first interlayer dielectric film 44 functions as an etching stopper, and no problem is caused in respect of the interlayer dielectric breakdown voltage or etching damage buffer. Therefore, it is not necessary to increase the thickness of the first interlayer dielectric film 38 in order to keep the margin, and the polymer is not deposited when etching the particle or contact hole at the time of film growth, and smear noise deterioration does not occur. It is hence possible to produce the solid-state image pickup devices with high quality at a stable yield.

Referring now to Figs. 3 to 7, the manufacturing method of the invention is described below.

First, on the principal plane of an N-type semiconductor substrate 51, a thermal oxide film 52 of about 100 nm in thickness is formed. A photoresist (not shown) is applied on the N-type semiconductor substrate 51, and the region of a first P-type diffusion layer 53 is exposed and developed, thereby forming a resist pattern. Using this resist pattern as the mask, boron ions are implanted. The ion implantation is performed under the conditions of an acceleration voltage of 100 keV and an implantation dose of about 10¹² cm⁻². Afterwards, in N₂ atmosphere, heat treatment is performed for several hours at a heat treatment temperature of 1100°C, and the boron ions are diffused to a depth of about 5 µm into the N-type semiconductor substrate 51, thereby forming a first P-type diffusion layer 53. At the same time, by this heat treatment, the ion-implanted boron is activated (Fig. 3).

Subsequently, a photoresist (not shown) is applied on the N-type semiconductor substrate 51, the region of a photodiode 54 is exposed and developed, thereby forming a resist pattern. Using this resist pattern as the mask, phosphorus ions are implanted. The ion implantation is performed under the conditions of an acceleration voltage of several hundred keV and an implantation dose of about 10¹² cm⁻². Later, in N₂ atmosphere, heat treatment is performed at 1000°C or higher. As a result, the implantation depth of the photodiode 54 is about 2 µm. Thus, the photodiode 54 is formed in the specified region of the first P-type diffusion layer 53.

Removing the resist on the N-type semiconductor substrate 51, a photoresist (not shown) is formed again on the N-type semiconductor substrate 51. By exposing and developing the region of a second P-type diffusion layer 55, a resist pattern is formed. Using this resist pattern as the mask, boron ions are implanted. The ion implantation is performed under the conditions of an acceleration voltage of about 100 keV and an implantation dose of 10¹² cm⁻². As a result, the diffusion depth of the second P-type diffusion layer 55 is finally about 1 µm. Thus is formed the second P-type diffusion layer 55 on the first P-type diffusion layer 53 which is a P-type well, for preventing the noise charges, generated in the N-type semiconductor substrate 51, from diffusing into the transfer channel.

After removing the resist pattern on the N-type semiconductor substrate 51, a photoresist (not shown) is formed on the N-type semiconductor substrate 51. By exposing and developing the transfer channel 56, a resist pattern is formed. Using this resist pattern as the mask, phosphorus ions are implanted. The ion implantation is performed under the conditions of an acceleration voltage of about 100 keV, and an implantation dose of 10¹² cm⁻². As a result, the diffusion depth of the transfer channel 56 is about 0.5 µm. Thus is formed the transfer channel 56.

Subsequently, removing the photoresist from the N-type semiconductor substrate 51, a photoresist (not shown) is formed again on the N-type semiconductor substrate 51. By exposing and developing the region of a third P-type diffusion region 57, a resist pattern is formed. Using the resist pattern as the mask, boron ions are implanted. The ion implantation is performed under the conditions of an acceleration voltage of scores of keV and an implantation dose of 10¹² cm⁻². As a result, the implantation depth of the third P-type diffusion layer 57 is about 1 µm. By implanting under such conditions the threshold voltage between the photodiode 54 and transfer channel 56 can be controlled. Thus is formed the third P-type diffusion layer 57 for controlling the potential required for reading out the photocarriers from the photodiode 54 to the transfer channel 56, between the photodiode 54 and transfer channel 56.

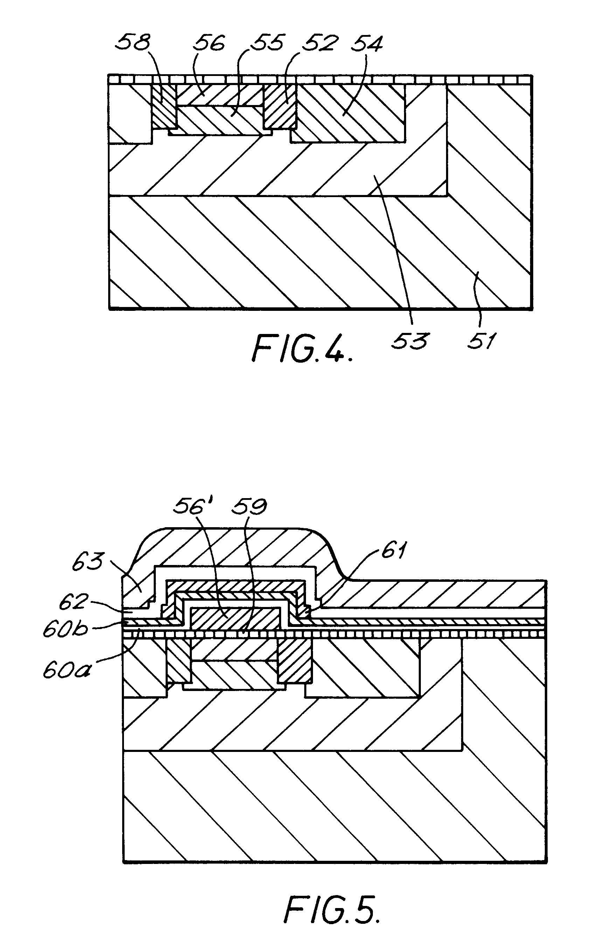

Next, removing the photoresist from the N-type semiconductor substrate 51, a photoresist (not shown) is applied again on the N-type semiconductor substrate 51. Exposing and developing the region for a fourth P-type diffusion layer 58, a resist pattern is formed. Boron ions are implanted in this resist pattern. The ion implantation is performed under the conditions of an acceleration voltage of scores of keV and an implantation dose of about 10¹³ cm⁻². As a result, the implantation depth of the fourth P-type diffusion layer 58 is about 1 µm. Since the fourth P-type diffusion layer 58 is separated from the adjacent element, the threshold voltage is set higher so that conduction does not occur at any voltage applied at the time of operation. For this purpose, the impurity concentration of the fourth P-type diffusion layer 58 is set relatively high. In particular, it should be set higher than the impurity concentration of the third P-type diffusion layer 57 (Fig. 4).

As a gate dielectric film 59, a silicon oxide film is grown to a thickness of about 50 nm by the pyrogenic oxidation method. Thereon, a polysilicon film is grown to a thickness of about 600 nm by the low pressure CVD method, and its sheet resistance is adjusted to about 10 Ω by phosphorus doping. On this polysilicon film, a photoresist is applied, and is exposed and developed, and a resist pattern of a transfer gate electrode 56' is formed. Using this resist pattern as the mask, the polysilicon film is subjected to reactive ion etching in a mixed atmosphere of fluoring gas and chlorofluorocarbon gas, thereby forming the transfer gate electrode 56'.

Afterwards, as an interlayer film 60a, a silicon oxide film of about 200 nm in thickness is grown by the pyrogenic oxidation method. To prevent lowering of a breakdown voltage due to pin holes or other defects in the polysilicon oxide film, an interlayer film 60b of silicon dioxide film is formed over it to a thickness of about 100 nm by the low pressure CVD method. The thickness of the polysilicon oxide film is about 200 nm. This value is set in order to prevent in-phase leakage which may occur when a driving pulse is applied. As the interlayer film 60b of the silicon oxide film, the silicon oxide film using TEOS gas is laid down in this embodiment. When the thickness of the interlayer film 60b is defined at 100 nm, its breakdown voltage may be set at 30 V or more.

A polysilicon film (hereinafter called a lower layer polysilicon film) is grown by about 100 nm. The thickness of the polysilicon film is 100nm in order to prevent peeling by the stress of the tungsten silicide film grown next (hereinafter called the upper layer tungsten silicide film) when the thickness of the polysilicon film is further thinned. The temperature at the time of growth of the polysilicon film is 900°C or lower, and because of this low temperature growth, the impurity profile of the diffusion layer in the N-type semiconductor substrate 51 is hardly changed. If the impurity profile is diffused or changed by heat, it may cause lowering of saturation output value in the reading characteristic for the solid-state image pickup device.

By the CVD method, a tungsten silicide film 61 is grown to about 200 nm. It is obtained by the reduction reaction between tungsten hexafluoride and hydrogen gas. At this film thickness, the light transmissivity is 0.02%. The tungsten silicide film may be formed by sputtering using a discharge in an argon gas atmosphere at 20 mTorr or less, instead of the CVD method. However, in the CVD method, since the step coverage is excellent, the tungsten silicide film is not reduced in thickeness in the step part at the side of the transfer gate electrode 35, and it is advantageous that a high opacity is obtained as in the case of a flat film.

A silicon oxide film to be used as a second interlayer dielectric film 62 is formed to a thickness of about 200 nm by the atmosphere pressure CVD method using silane gas and oxygen. The atmosphere pressure CVD method is employed because the process may be simplified by growing the second interlayer dielectric film 62 simultaneously in the same apparatus as the first interlayer dielectric film 63 grown in the atmosphere pressure CVD method. For example, moreover, a silicon oxide film laid down by the low pressure CVD method using TEOS gas may be used as the second interlayer dielectric film 62. The thickness of the second interlayer dielectric film 62 alone can achieve the following two purposes. Firstly, it offers a buffer layer for preventing generation of crystal defects in the photodiode 54 by etching damage at the time of dry etching for patterning the second light-shield film 64 in a later process. Secondly, a dielectric breakdown voltage is maintained between the transfer gate electrode 56' and the wiring layer composed of the first light-shield film 61, second light-shield film 64 and wiring layer 65. On the other hand, if the thickness of the second interlayer dielectric film 62 is increased for the above purposes, the light entering and penetrating the first light-shield film 61 from an oblique direction increases, and smear noise is generated, and therefore it is not desired to increase the thickness more than necessary.

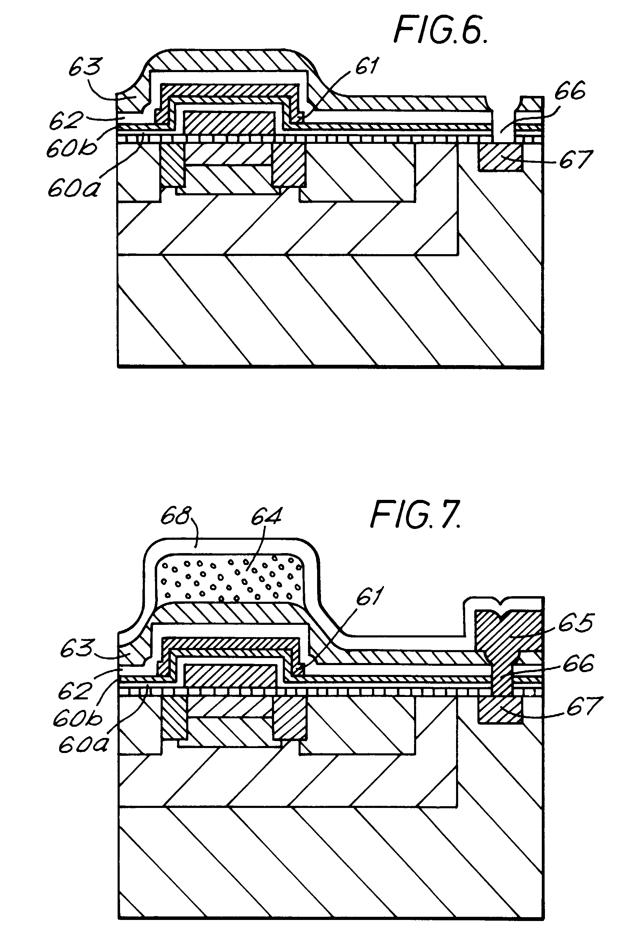

Subsequently, a BPSG film is formed as a first interlayer dielectric film 63 by the atmosphere pressure CVD method using a mixture of silane gas, phosphine gas and diborane gas. The mixing ratio of silane gas, phosphine gas and diborane gas is determined so that the boron and phosphorus concentration of the BPSG film are about 3 wt.% and about 6 wt.%, respectively. The thickness of this BPSG film is about 600 nm. Next, in an N₂ atmosphere, by heat treatment at 900°C, a flow is induced in this BPSG film, and the uppermost surface of the first interlayer dielectric film 63 is smoothed. As a result of viscous fluidity at this time, the thickness of the first interlayer dielectric film 63 is about 30 nm in the step area of the first light-shield film 61. By heat treatment at 900°C or higher, the impurity profile of the diffusion layer formed so far on the N-type semiconductor substrate 51 is changed, and the reading characteristic and saturation output of the solid-state image pickup device are lowered. Herein, the reason of heat treatment in N₂ atmosphere, instead of heat treatment in pyrogenic atmosphere where a more favourable flat shape can be obtained is that the pyrogenic molecules passing through the first interlayer dielectric film 63 and second interlayer dielectric film 62 oxidize the silicide film which makes up the first light-shield film 61 spoil its shape (Fig. 5).

A photoresist (not shown) is formed on the first interlayer dielectric film 63, and the desired contact hole region including a contact hole 66 is exposed and developed, and a resist pattern for contact hole is formed. Using this resist pattern as the mask, reactive ion etching is effected by fluorohydrocarbon gas. Thus, the contact hole 66 is formed.

When heated at 900°C in a mixed gas atmosphere of POCI₃ and O₂, a phosphorus glass film (P₂O₅ film not shown), about 50 nm thick, is formed on the surface of the semiconductor device. At the same time, phosphorus is diffused in the solid phase from the phosphorus glass film and an N-type diffusion layer 65 is formed. This heat treatment should be preferably done at 900°C so that the various diffusion layers formed so far on the N-type semiconductor substrate 51 are not diffused thermally. The sheet resistance of the N-type diffusion layer 65 is 5 to 10 Ω/□. At this time, phosphorus is diffused in the solid phase similarly on the reverse side (not shown) of the N-type semiconductor substrate 51. By this phosphorus diffusion layer, a gettering layer is formed for gettering the heavy metal elements which are impurities adversely affecting the elements and causing crystal defect, and it is very useful. The sheet resistance of this gettering layer is also 5 to 10 Ω/□.

Subsequently, using a mixed solution of hydrofluoric acid and water, the phosphorus glass film grown on the entire surface of the solid-state image pickup device is removed. The mixing ratio of water:hydrofluoric acid is preferably about 20:1, from the viewpoint of controllability of etching and through-put. If the mixing ratio of hydrofluoric acid is smaller, the etching time may be extended. If the mixing ratio of hydrofluoric acid is greater, the etching controllability is impaired. The etching time at this mixing ratio may be about 20 seconds. At this time, since the first interlayer dielectric film 63 is also etched and the thickness decreases in a range of 20 nm to 40 nm, and the second interlayer dielectric film 62 may be exposed in the step area of said first light-shield film 61 (Fig. 6).

By sputtering using discharging in an argon atmosphere of 20 mTorr or less the silicon-containing aluminium film is stacked up, and a photoresist is applied (not shown), and a resist pattern of a second light-shield film 64 and wiring layer 65 is formed. Using this resist pattern as the mask, reactive ion etching is performed in chlorine gas, and the second light shield 64 and wiring layer 65 are formed. If crystal defects occurs in the photodiode 54, high temperature heat treatment at about 900°C for recovering it cannot be applied. Hence, this etching is desired to be performed using discharge RF power at a low level so as to cause the damage.

Finally, a silicon oxide film is formed by the plasma enhanced CVD method using mixture of silane gas and N₂O is laid down to about 400 nm, and a final protective film 68 is formed, thereby completing the solid-state image pickup device of the invention (Fig. 7).

In this embodiment, the wet etching process for removing the phosphorus glass film is employed, but if the specified etching is applied on the first interlayer dielectric film 63 in other process, if the etching rate of the second interlayer dielectric film 62 is slower than that of the first interlayer dielectric film 63 in this specified etching, the same effect as in the embodiment is obtained.

In this embodiment, a tungsten polycide film was used as the first light-shield film 61, but it is not limitative. Any light-shield material withstanding heat treatment at around 900°C may be used, and, for example, a molybdenum polycide film having a superior light-shield property may be used.

Likewise, the film is not limited to a refractory metal polycide film, for example, a refractory metal film comprising, for example, tungsten or molybdenum alone may be used. In this case, since the light-shield performance is higher than in the refractory metal polycide film, the effect on smear noise may be enhanced.

A molybdenum silicide film on a tungsten film can be formed in the same manner as the tungsten silicide film. In the embodiment, however, in order to prevent oxidation of the refractory metal silicide fil, smoothing treatment of the first interlayer dielectric film 63 is effected in N₂ atmosphere, but the smoothing treatment may be done in pyrogenic atmosphere if the first light-shield film 61 is formed using only one layer of refractory metal film.

Similarly, in the embodiment, a dielectric film of silicon oxide film is used as the interlayer film 60b, but when, for example, a silicon nitride film, having higher insulation, is laid down by the low pressure CVD method, the film may be thinner and smear noise may be reduced.

In the embodiment, as the second interlayer dielectric film 62, a silicon oxide film grown by the CVD method was used, but is not limitative. Of the insulating films of which etching rate to specified etching is sufficiently slow as compared with the first interlayer dielectric film 63, any material with the property of transmitting the incident light into the photodiode 54 may be used. For example, a silicon nitride film or a silicon oxy-nitride film laid down by low pressure CVD method may be employed. The etching rate in a mixed solution of water:hydrofluoric acid of 20:1 used in the embodiment is about 0.2 nm/min in a silicon nitride film, and it functions sufficiently as the etching stopper.

In the embodiment, the BPSG film was used as the first interlayer dielectric film 63, but, for example, a phosphosilicate glass (PSG) film grown by the atmosphere pressure CVD method with phosphine gas and silane gas may be used. The phosphorus content of the PSG film used as the first interlayer dielectric film 63 is desired to be about 8 wt.% or less. If the phosphorus content is higher, the phosphorus induced to outward diffusion in smoothing heat treatment may react with the film surface to form granular foreign matter, or the phosphorus may corrode the aluminium which forms the wiring layer 65 or the second light-shield film 64. However, when the PSG film is used, the smoothed shape is worse than in the case of the BPSG film, and therefore it is necessary to reduce the step preliminary by thinning the transfer gate electrode 56 and first light-shield film 61. Although the smoothed shape may be improved by raising the heat treatment temperature or extending the heat treatment time, it is not desired because the element characteristic is deteriorated by changing the impurity profile of the diffusion layer in the N-type semiconductor substrate 51.

Alternatively, as the first interlayer dielectric film 63, a simultaneous film growth and smoothing technique, such as the CVD film using ozone and TEOS gas, may be used. In this case, the heat treatment for smoothing at about 900°C is not needed. Using this ozone TEOS film, the etching rate in the mixed solution of water:hydrofluoric acid of 20:1 used in the embodiment is about 150 nm/min.

In the foregoing embodiment, although the second light-shield film 64 and wiring layer 65 were formed and patterned in the same process, this method is not limitative. For example, pure aluminium may be used as the second light-shield film 64, and silicon-containing aluminium, silicon or copper-containing aluminium may be used as the wiring layer 65. In this case the second light-shield film 64 and wiring layer 65 are manufactured in separate steps. Since both layouts do not cross on a plane, it is not necessary to form a new interlayer dielectric film between the two. In this case, the same film forming and patterning processes as in the embodiment may be repeated.

In the foregoing embodiment, the BPSG film was used as the first interlayer dielectric film and the NSG film using atmosphere pressure CVD for the second interlayer dielectric film, but these materials are not limitative. For example, as the first interlayer dielectric film, a material that can be smoothed by heat treatment, such as a phosphosilicate glass (PSG) film may be used. In the embodiment, after laying down the first interlayer dielectric film, the uppermost surface is smoothed by heat treatment, but this processing is not limitative, and, for example, the first interlayer dielectric film may be formed by using a material which is smoothed as it is laid down, such as the Si0 laid down by the atmosphere pressure CVD method or low pressure CVD using a mixed gas of ozone (O₃) and TEOS (Si(OC₂H₅)₄). Or, as the second interlayer dielectric film, a material of a dense film texture is suited, and, for example, a silicon nitride film or a silicon oxy-nitride film may be used.

In the embodiment, the interlayer dielectric film is composed of a two-layer structure but the interlayer dielectric film may be composed of three or more layers in which the first interlayer dielectric film and second interlayer dielectric film of the invention are included as the constituent elements.

## Claims

1. A solid-state image pickup device comprising:
a semiconductor substrate (31);
a photodiode (32) formed in said semiconductor substrate;
a transfer channel (33, 46) formed in said semiconductor substrate spaced from the photodiode;
a transfer gate electrode (35) formed over said transfer channel on a gate dielectric film (34);
an interlayer film (36) formed on said transfer gate electrode;
a first light-shield film (37) formed on said interlayer film for shielding the transfer channel from light;
a second light-shield film (42) formed over the first light shield film; and an interlayer dielectric film (38, 44) between said first and second light-shield layers,
**characterised in that** the interlayer dielectric film comprises a multiple-layer film of at least a first interlayer dielectric film (38) and a second interlayer dielectric film (44), said second interlayer dielectric film (44) is of a material having a lower etching rate than that of said first interlayer dielectric film (38) for the same etchant, and the second interlayer dielectric film is formed beneath the first interlayer dielectric film.

2. A solid-state image pickup device according to claim 1, wherein said first interlayer dielectric film (38) is a silicon oxide film, and said second interlayer dielectric film (44) is a silicon oxide film containing at least one of boron and phosphorus.

3. A solid-state image pickup device according to claim 1 or 2, wherein the voltage applied to said transfer gate electrode is controlled by four-phase driving pulses.

4. A solid-state image pickup device according to claim 1, 2 or 3, wherein a P type diffusion layer (45) is provided so as to surround the transfer channel, thereby providing an Hi-C structure.

5. A solid-state image pickup device according to any one of claims 1 to 4, wherein said interlayer film (36) is formed as a multiple layer film of polysilicon oxide film (36a) and silicon oxide (36b).

6. A solid-state image pickup device according to any one of claims 1 to 5, wherein said first light-shield film (37) is formed in a multiple layer film of polysilicon film and tungsten silicide film.

7. A method of manufacturing a solid-state image pickup device comprising:
forming a photodiode (54) in a semiconductor substrate;
forming a transfer channel (56) in said semiconductor substrate spaced from said photodiode;
forming a gate dielectric film (59) on said semiconductor substrate;
forming a transfer gate electrode (56') on the gate dielectric film;
forming an interlayer film (60a, 60b) on said transfer gate electrode;
forming a first light-shield film (61) on said interlayer film for shielding said transfer channel from light;
forming an interlayer dielectric film (62, 63) on said first light-shield film; smoothing said dielectric film;
forming a second light-shield film (64) on said interlayer dielectric film; and removing a portion of said second light-shield film by etching,
**characterised in that** said interlayer dielectric film comprises first and second interlayer dielectric films (63, 62) and is formed by forming the second interlayer dielectric film (62) on said first light shield film (61) and thereafter forming the first interlayer dielectric film (63) on said second interlayer dielectric film (62), said second interlayer dielectric film (62) being formed of a material having a lower etching rate than that of said first interlayer dielectric film (63) for the same etchant.

8. A method according to claim 7, wherein the smoothing includes heat treatment of said first interlayer dielectric film at a temperature for allowing an impurity contained in said first interlayer dielectric film to diffuse outward, not reacting in vapor phase.

9. A method according to claim 7 or 8, wherein said first interlayer dielectric film has a boron concentration of 1.2 wt % or more.

10. A method according to claim 7, 8 or 9, wherein said first interlayer dielectric film is a material smoothed by heat treatment at 900° in N₂ atmosphere.

11. A method according to any one of claims 7 to 10, wherein first interlayer dielectric film has a tapered shape over the transfer gate electrode (56').

## Patentansprüche

1. Festkörper-Bildaufnahmevorrichtung, mit
einem Halbleitersubstrat (31),
einer Photodiode (32), die auf dem Halbleitersubstrat gebildet ist;
einem Übertragungskanal (33, 46), der auf dem Halbleitersubstrat in einem Abstand von der Photodiode ausgebildet ist;
einer Übertragungsgateelektrode (35), die über dem Übertragungskanal auf einem dielektrischen Gatefilm (34) ausgebildet ist;
einem Zwischenschichtfilm (36), der auf der Übertragungsgateelektrode ausgebildet ist;
einem ersten Lichtabschirmungsfilm (37), der auf dem Zwischenschichtfilm ausgebildet ist, um den Übertragungskanal von Licht abzuschirmen;
einem zweiten Lichtabschirmungsfilm (42), der über dem ersten Lichtabschirmungsfilm ausgebildet ist; und
einem dielektrischen Zwischenschichtfilm (38, 44) zwischen der ersten und der zweiten Lichtabschirmungsschicht,
dadurch gekennzeichnet, daß der dielektrische Zwischenschichtfilm einen Mehrschichtfilm aus wenigstens einem ersten dielektrischen Zwischenschichtfilm (38) und einem zweiten dielektrischen Zwischenschichtfilm (44) enthält, wobei der zweite dielektrische Zwischenschichtfilm (44) aus einem Material besteht, das für das gleiche Ätzmittel eine niedrigere Ätzrate als jene des ersten dielektrischen Zwischenschichtfilms (38) besitzt und wobei der zweite dielektrische Zwischenschichtfilm unter dem ersten dielektrischen Zwischenschichtfilm ausgebildet ist.

2. Festkörper-Bildaufnahmevorrichtung nach Anspruch 1, bei der der erste dielektrische Zwischenschichtfilm (38) ein Siliciumoxidfilm ist und der zweite dielektrische Zwischenschichtfilm (44) ein Siliciumoxidfilm ist, der Bor und/oder Phosphor enthält.

3. Festkörper-Bildaufnahmevorrichtung nach Anspruch 1 oder 2, bei der die an die Übertragungsgateelektrode angelegte Spannung durch Vierphasen-Treiberimpulse gesteuert wird.

4. Festkörper-Bildaufnahmevorrichtung nach Anspruch 1, 2 oder 3, bei der eine P-Typ-Diffusionsschicht (45) so vorgesehen ist, daß sie den Übertragungskanal umgibt, wodurch eine Hi-C-Struktur geschaffen wird.

5. Festkörper-Bildaufnahmevorrichtung nach irgendeinem der Ansprüche 1 bis 4, bei der der Zwischenschichtfilm (36) als Mehrschichtfilm aus einem Polysiliciumoxidfilm (36a) und einem Siliciumoxid ausgebildet ist.

6. Festkörper-Bildaufnahmevorrichtung nach irgendeinem der Ansprüche 1 bis 5, bei der der erste Lichtabschirmungsfilm (37) als Mehrschichtfilm aus einem Polysiliciumfilm und einem Wolframsilicitfilm ausgebildet ist.

7. Verfahren zum Herstellen einer Festkörper-Bildaufnahmevorrichtung, enthaltend:
Ausbilden einer Photodiode (54) auf einem Halbleitersubstrat;
Ausbilden eines Übertragungskanals (56) im Halbleitersubstrat in einem Abstand von der Photodiode;
Ausbilden eines dielektrischen Gatefilms (59) auf dem Halbleitersubstrat;
Ausbilden einer Übertragungsgateelektrode (56') auf dem dielektrischen Gatefilm;
Ausbilden eines Zwischenschichtfilms (60a, 60b) auf der Übertragungsgateelektrode;
Ausbilden eines ersten Lichtabschirmungsfilms (61) auf dem Zwischenschichtfilm, um den Übertragungskanal von Licht abzuschirmen;
Ausbilden eines dielektrischen Zwischenschichtfilms (62, 63) auf dem ersten Lichtabschirmungsfilm;
Glätten des dielektrischen Films;
Ausbilden eines zweiten Lichtabschirmungsfilms (64) auf dem dielektrischen Zwischenschichtfilm; und
Entfernen eines Teils des zweiten Lichtabschirmungsfilms durch Ätzung,
dadurch gekennzeichnet, daß der dielektrische Zwischenschichtfilm einen ersten und einen zweiten dielektrischen Zwischenschichtfilm (63, 62) enthält und dadurch gebildet wird, daß der zweite dielektrische Zwischenschichtfilm (62) auf dem ersten Lichtabschirmungsfilm (61) ausgebildet wird und danach der erste dielektrische Zwischenschichtfilm (63) auf dem zweiten dielektrischen Zwischenschichtfilm (62) ausgebildet wird, wobei der zweite dielektrische Zwischenschichtfilm (62) aus einem Material besteht, das für dasselbe Ätzmittel eine niedrigere Ätzrate als diejenige des ersten dielektrischen Zwischenschichtfilms (63) besitzt.

8. Verfahren nach Anspruch 7, bei dem die Glättung eine Wärmebehandlung des ersten dielektrischen Zwischenschichtfilms mit einer Temperatur, die eine Diffusion der im ersten dielektrischen Zwischenschichtfilm enthaltenen Störstellen nach außen ohne Reaktion in der Dampfphase zuläßt, umfaßt.

9. Verfahren nach Anspruch 7 oder 8, bei dem der erste dielektrische Zwischenschichtfilm eine Borkonzentration von 1,2 Gew.-% oder mehr besitzt.

10. Verfahren nach Anspruch 7, 8 oder 9, bei dem der erste dielektrische Zwischenschichtfilm ein Material ist, das durch eine Wärmebehandlung bei 900° in einer N₂-Atmosphäre geglättet wird.

11. Verfahren nach irgendeinem der Ansprüche 7 bis 10, bei dem der erste dielektrische Zwischenschichtfilm über der ersten Übertragungsgateelektrode (56') eine konisch zulaufende Form besitzt.

## Revendications

1. Dispositif analyseur d'images à l'état solide comprenant :
un substrat semiconducteur (31);
une photodiode (32) formée dans ledit substrat semiconducteur;
un canal de transfert (33,46) formé dans ledit substrat semiconducteur et espacé de la photodiode;
une électrode de grille de transfert (35) formée au-dessus dudit canal de transfert sur un film diélectrique de grille (34);
un film inter-couches (36) formé sur ladite électrode de grille de transfert;
un premier film (37) formant écran pour la lumière, formé sur ledit film inter-couches pour protéger le canal de transfert vis-à-vis de la lumière;
un second film (42) formant écran pour la lumière formé sur le premier film formant écran pour la lumière; et
un film diélectrique inter-couches (38,44) situé entre lesdites première et seconde couches formant écran vis-à-vis de la lumière,
caractérisé en ce que le film diélectrique inter-couches comprend un film à couches multiples comprenant au moins un premier film diélectrique inter-couches (38) et un second film diélectrique inter-couches (44), ledit second film diélectrique inter-couches (44) étant formé d'un matériau dans lequel la vitesse d'attaque est plus faible que dans ledit premier film diélectrique inter-couches (38) pour le même agent corrosif, et le second film électrique inter-couches est formé au-dessous du premier film diélectrique inter-couches.

2. Dispositif analyseur d'images à l'état solide selon la revendication 1, dans lequel ledit premier film diélectrique inter-couches (38) est un film d'oxyde de silicium et ledit second film diélectrique inter-couches (44) est un film d'oxyde de silicium contenant au moins l'un de bore et de phosphore.

3. Dispositif analyseur d'images à l'état solide selon la revendication 1 ou 2, dans lequel la tension appliquée à ladite électrode de grille de transfert est commandée par des impulsions de commande à quatre phases.

4. Dispositif analyseur d'images à l'état solide selon la revendication 1, 2 ou 3, dans lequel une couche de diffusion (45) de type P est prévue de manière à entourer le canal de transfert, ce qui fournit une structure Hi-C.

5. Dispositif analyseur d'images à l'état solide selon l'une quelconque des revendications 1 à 4, dans lequel ledit film inter-couches (36) est agencé sous la forme d'un film à couches multiples comprenant un film d'oxyde de polysilicium (36a) et d'oxyde de silicium (36b).

6. Dispositif analyseur d'images à l'état solide selon l'une quelconque des revendications 1 à 5, dans lequel ledit premier film (37) formant écran pour la lumière est formé dans un film à couches multiples comprenant un film de polysilicium et un film de siliciure de tungstène.

7. Procédé pour fabriquer un dispositif analyseur d'images à l'état solide consistant à :
former une photodiode (54) dans un substrat semiconducteur; former dans ledit substrat semiconducteur un canal de transfert (56) distant de ladite photodiode;
former un film diélectrique de grille (59) sur ledit substrat semiconducteur;
former une électrode de grille de transfert (56') sur le film diélectrique de grille;
former un film inter-couches (60a,60b) sur ladite électrode de grille de transfert;
former un premier film (61) formant écran pour la lumière sur ledit film inter-couches pour protéger ledit canal de transfert vis-à-vis de la lumière;
former un film diélectrique inter-couches (62,63) sur ledit premier film formant écran pour la lumière;
lisser ledit film diélectrique;
former un second film (64) formant écran pour la lumière sur ledit film diélectrique inter-couches; et
supprimer par attaque une partie dudit second film formant écran pour la lumière,
caractérisé en ce que ledit film diélectrique inter-couches comprend des premier et second films diélectriques inter-couches (63,62) et est formé au moyen de la formation du second film diélectrique inter-couches (62) sur ledit premier film (61) formant écran pour la lumière, puis par formation du premier film diélectrique inter-couches (63) sur ledit second film diélectrique inter-couches (62), ledit second film diélectrique inter-couches (62) étant formé d'un matériau, dans lequel la vitesse d'attaque est plus faible que dans ledit premier film diélectrique inter-couches (63) pour le même agent d'attaque.

8. Procédé selon la revendication 7, dans lequel le lissage comprend un traitement thermique du premier film diélectrique inter-couches à une température permettant à une impureté contenue dans ledit premier film diélectrique inter-couches de diffuser vers l'extérieur, sans réagir en phase vapeur.

9. Procédé selon la revendication 7 ou 8, dans lequel ledit premier film diélectrique inter-couches possède une concentration de bore égale à 1,2 % en poids ou plus.

10. Procédé selon la revendication 7, 8 ou 9, dans lequel ledit premier film diélectrique inter-couches est formé d'un matériau lissé au moyen d'un traitement thermique à 900° dans une atmosphère de N₂.

11. Procédé selon l'une quelconque des revendications 7 à 10, dans lequel le premier film diélectrique inter-couches possède une forme conique au-dessus de l'électrode de grille de transfert (56').
